Europäisches Patentamt

European Patent Office

Office européen des brevets

(11) Publication number: **0 246 079**
**A2**

# EUROPEAN PATENT APPLICATION

(21) Application number: **87304238.6**

(22) Date of filing: **13.05.87**

(51) Int. Cl.⁴: **G 06 F 11/20**

(30) Priority: **14.05.86 GB 8611794**

(43) Date of publication of application:
**19.11.87 Bulletin 87/47**

(84) Designated Contracting States:
**BE CH DE ES FR IT LI NL SE**

(71) Applicant: **The General Electric Company, p.l.c.**
**1 Stanhope Gate**
**London W1A 1EH (GB)**

(72) Inventor: **Williams, Howard**
**8 Sunnyside Close**
**Chapelfields Coventry CV5 8DL (GB)**

**Harrold, David Richard**
**14 Shadrach Close**
**Stoney Stanton Leicestershire LE9 6TN (GB)**

(74) Representative: **MacKenzie, Ian Alastair Robert**
**The General Electric Company, p.l.c. Central Patent**
**Department Wembley Office Hirst Research Center East**
**Lane**
**Wembley Middlesex HA9 7PP (GB)**

(54) Microprocessor back-up system.

(57) A back-up system for the main processor of a digital telephone exchange comprises a storage array (120) of CMOS dynamic RAMS. Failure of the normal power supply triggers power changeover logic (20) so that the array (120) is refreshed in a manner to make best possible use of the failing power supply. Thereafter the system supplies regular refreshing to the array (120) but prevents changes in the data already stored.

Fig.3.

EP 0 246 079 A2

# Description

## Microprocessor Back-up System

The present invention concerns back-up stores for the main processors of digital telephone exchanges. Back-up stores are used to maintain essential data in the event of the main processor malfunctioning. In the event of such a malfunction the back-up system stores billing data, operating system data and exchange configuration data.

So far the provision of back-up storage has involved the use of static memories such as bubble-memories with their very low current and voltage requirements. However, bubble-memories also have limitations with regard to size. Also the access time to bubble-memories is relatively slow.

The present invention has for an object to provide an alternative form of back-up storage.

Accordingly the present invention consists in a back-up system for the main processor of a digital telephone exchange, for system comprising a storage array of CMOS dynamic RAM's, means for detecting failure in the normal power supply, means for switching from the normal power supply to a secure back-up supply on detection of failure of the former, and means for providing a regular refresh of the storage array after such switching has taken place.

Preferably the back-up system includes a microprocessor controlling read/write operation from and into the CMOS storage array and the back-up system includes means for providing a burst or rapid refresh as soon as power failure is detected, and for periodic, cyclical refresh of the CMOS array thereafter.

According to a feature of the invention the array is arranged in a plurality of banks, and the CMOS devices of one bank only are refreshed at any one time of the refresh cycle.

In order that the present invention may be more readily understood, an embodiment thereof will now be described by way of example and with reference to the accompanying drawings, in which

Figure 1 is a block diagram of the change over and refresh logic of a back-up system for the main processor of a digital telephone exchange according to the present invention

Figure 2 is a block diagram showing the power up/power down signal interface, and

Figure 3 is a block diagram of the entire back-up system.

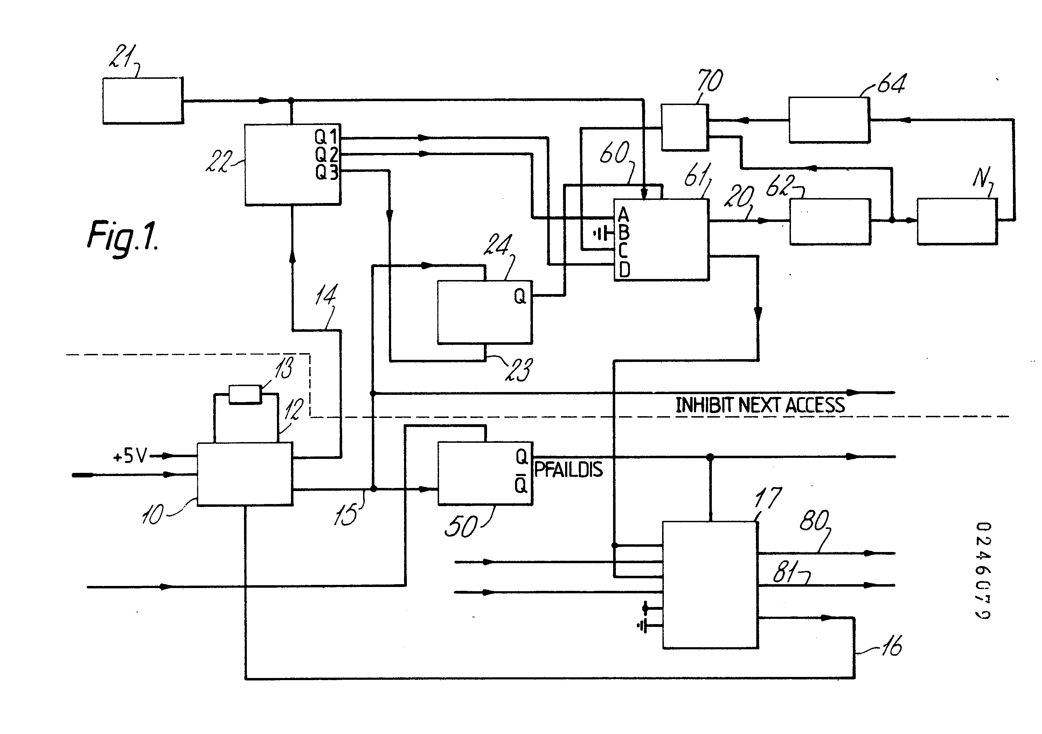

Referring now to Figure 1 of the drawings, the first function of the control circuitry shown in this Figure is to detect failure of the exchange processor. The cause of failure for which the back-up store is intended is that of the processor power supply which is unsecured. The condition of this supply is detected at 10 and supplied in parallel with +5V battery source 11 to a monostable 12. The response of monostable 12 is tuned by a delay circuit 13 to produce a 3 microsecond delay. On triggering of the monostable 12 an output pulse is generated on line 15. Line 15 is connected to a memory sequencer built from two logic arrays which control read/write operations not required during back-up. The signal on line 15 terminates current operation after allowing the memory sequencer to finish. Line 15 is the path for resetting the power down refresh logic in preparation for takeover from the unsecured power supply.

The power down refresh circuit is generally indicated at 20 and includes a 4 MegaHertz CMOS oscillator 21 which provides a base clock for the system and from which the various clock signals are derived by a counter chain 22. One output from counter chain 22 is on line 23 and this is supplied to one input of a flip-flop 24 which changes between burst refresh and lower power refresh at the end of the count from the counter chain 22. The burst refresh of the CMOS back-up store RAM is carried out quickly, making the best possible use of the failing unsecured power supply, in order to ensure that each row address receives a 4 ms type refresh before the 32 ms type refresh without an intervening read or write cycle. The reset pulse for flip-flop 24 is taken from output line 15 from monostable 12.

Line 15 is connected to the clock input of a D-type flip-flop 50 and causes a signal referred to as PFAILDIS to clock low. PFAILDIS appears at the Q output of flip-flop 50 and is connected to selector circuit 17. When PFAILDIS goes low, selector circuit 17, which is a quad 2 to 1 multiplexer, goes into its back-up mode and generates a clear signal on line 16 which is supplied to the CLEAR input of monostable 12 to ensure that the latter takes no further notice of signals appearing on line 10.

PFAILDIS, as well as changing selector circuit 17 into back-up mode, also inhibits Write and Column Address strobes to the CMOS dynamic store. This means that the data in the back-up store remains unchanged. PFAILDIS also inhibits routine testing of the unit back-up battery which takes place during normal operation.

The signal on line 15 is also supplied to a flip-flop 24 having two control inputs and when low sets flip-flop 24 into burst-refresh mode. The reasons for burst-refresh have already been described. To do this the Q output of flip-flop 24 is connected via a line 60 to the SELECT input of a selector circuit 61. Selector circuit 61 in response to the signal from flip-flop 24 uses a 2 MegaHertz clock signal derived from a 4 MegaHertz oscillator 21 to generate Row Address Strobe (RAS) pulses which act through circuit 17, already in back-up mode, to drive the RAS generation circuitry. The output of oscillator 21 is supplied to a 12 stage binary counter chain 22 having three effective outputs, $Q_1$ at 2 MegaHertz, $Q_2$ at 1 MegaHertz and $Q_{12}$ at 1 KiloHertz. The $Q_1$ output is used for burst-refresh and passes through selector circuit 61 to circuit 17 where it emerges to be carried by line 80 to the appropriate RAS control circuitry to be described later in this specification. In response to the pulse chain selector 17 also provides refresh control pulses on line 81. The counter chain 22 is reset by a pulse in line 14 from monostable 12 and provides the various clock signals for the system. The output from $Q_{12}$ appears at the end of the count from counter chain 22 and is supplied to the RESET input of flip-flop 24. The appearance of this signal changes the flip-flop 24 from the burst-refresh mode instigated by the pulse on line 15 into lower power refresh. In this mode the output of flip-flop 24 sets selector 61 to accept the 1 MegaHertz input from counter chain 22 and supplies the 1 MegaHertz signal to a divider chain 62.

The output of divider chain 62 is supplied to a passive delay line driver 65 in turn connected to a passive delay line 64 with the output of delay line 64 being connected to one input of an AND-gate 70, the other input of which is the direct output of divider chain 62. The effect of this circuit is to generate a chain of pulses having 160 microseconds width, which pulse chain passes straight through selector circuit 61 to selector circuit 17. The latter circuit has already been set in its power fail mode and the pulse chain is used to drive the refresh circuity and row address control.

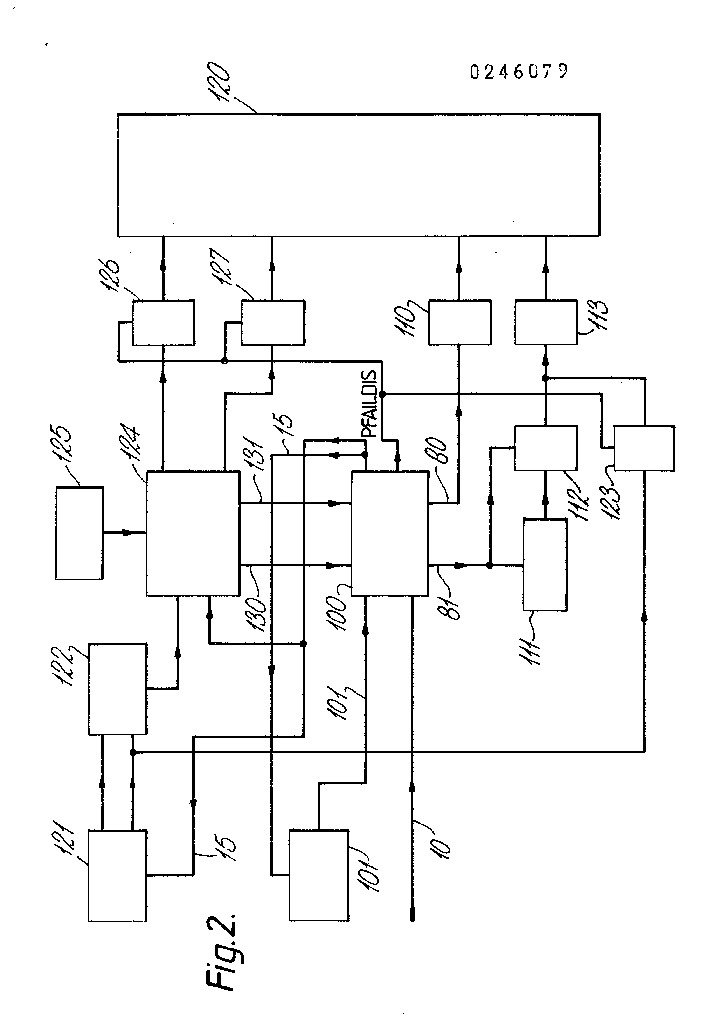

Referring now to Figure 2 of the drawings, this shows the entire power up/down signal interface in greater detail. The block shown in this drawing at 100 effectively consists of the circuit elements 12, 13, 17 and 50 of Figure 1, and comprises the power changeover logic whilst block 101 includes the remaining circuit elements of Figure 1. Thus line 15 is duplicated in both figures as is line 80 on which the RAS control pulses appear, and line 81 for the refresh control pulses. In Figure 2 the line 101 represents the various clock signals derived from counter chain 22 of Figure 1.

Line 80 is connected to a RAS sequency circuit 110 which controls the supply of Row Address Strobes to the CMOS dynamic RAM array 120. Line 81 is connected to a circuit 111 which generates the addresses to which refresh pulses are to be applied and to the enable input of a refresh address buffer 112. The buffer 112 is connected to an address driver circuit 113 in turn connected to the array 120.

The circuit shown in Figure 2 also includes a microprocessor 121 which controls the back-up store during normal, power-up, operation. In normal operation, that is until it is inhibited by the signal on line 15, this circuit sends commands and addresses to a microprocessor support circuit 122, and the addresses to a microprocessor address buffer 123 effectively connected in parallel with refresh address buffer 112, the output of buffer 123 also being connected to address driver circuit 113.

Microprocessor support circuit 122 has its output connected to a circuit 124 which under the timing control of a circuit 125 supplies Column Address Strobes (CAS) to a driver circuit 126, and Write Enable signals to another driver circuit 127. When power failure has been detected the PFAILDIS signal inhibits the driver circuits 126, 127 and microprocessor address buffer 123 so that no new data is written into or read from array 120 and only the refresh, write RAS and CAS pulses of the access in progress are allowed to reach array 120.

The circuit 124 during power-up operation supplies control signals on line 130 to the power changeover logic circuit 101. When the unsecured power supply has failed so that power-down operation has started RAS pulses on line 131 from circuit 124 are inhibited.

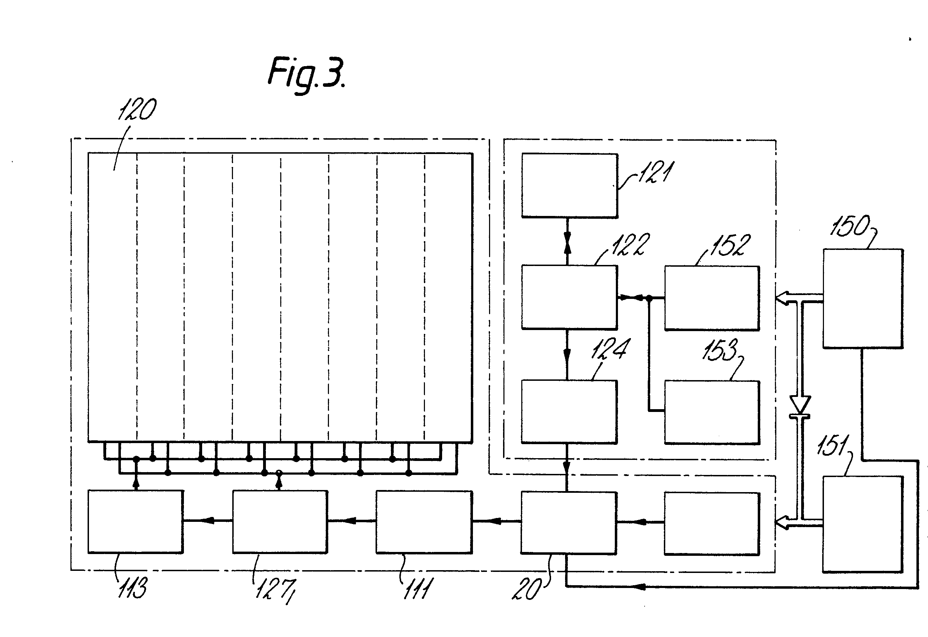

Referring now to Figure 3 of the drawings this shows at 150 the unsecured supply used in normal, power-up operation. Also shown is the secure, battery-backed supply 151. Circuit elements shown in common with Figures 1 and 2 have the same reference numerals. Also shown is a multibus interface 152 and a SCSI (Small Computer Systems Interface) 153 which is used to drive a hard disc store. The CMOS array 120 comprises 8 banks of 256 kilowords by 1 dynamic CMOS RAM's. Each bank contains 17 dynamic RAM's, giving a total of 136 devices. The array can store two megawords with each word being defined as 16 bits of data plus 1 parity bit. The CMOS technology gives low power consumption together with fast access times.

In the present embodiment the refresh time for a particular row within a device in the array is 32 milliseconds when in the battery backed-up mode. Because of power restrictions the logic of the refresh circuitry is such that in back-up mode refresh is performed on only one bank at any one time.

Pages written in the array 120 are protected against corruption during power-down because all page dumps are performed in two parts. The data is first written into a temporary page and then transferred to the destination page. A flag is set before the second transfer by the microprocessor 121. If power fails during this second transfer then the system will examine the flag when power returns and re-perform the transfer if necessary. This ensures that a RAM page either remains unwritten or is completely overwritten with valid data.

**Claims**

1. A back-up system for the main processor of a digital telephone exchange, the system comprising a storage array (120), means (10) for detecting failure of the normal power supply, means (100) for switching from the normal power supply to a back-up supply, and characterised in that the storage array (120) is of dynamic CMOS RAM's, and that the system includes means (20) for providing a regular refresh of the storage array (12) after such a switching has taken place.

2. A system as claimed in Claim 1, and further characterised in that it includes a microprocessor (124) for controlling read/write operation from and into said CMOS array.

3. A system as claimed in Claim 2, and further characterised in that it includes means for providing a rapid refresh as soon as power failure is detected, and for periodic, cyclical refresh of said CMOS array thereafter.

4. A system as claimed in Claim 3, and further characterised in that said CMOS array (120) is arranged in a plurality of banks, the CMOS devices of one bank only being refreshed at any one time of the refresh cycle.

5. A system as claimed in Claim 4, and further characterised in that said power failure detecting means comprise a monostable (10) timed by a delay circuit (13) to provide a predetermined delay, said monostable (10) being connected to a memory sequencer circuit which controls read/write operations not required during back-up.

6. A system as claimed in Claim 5, and further characterised in that it includes a power down refresh circuit (20) which includes an oscillator (21) which provides a base clock during power down operation.

7. A system as claimed in Claim 6, and further characterised in that the power down refresh circuit (20) includes a first counter chain (22) supplied by said oscillator to generate clock signals.

8. A system as claimed in Claim 7, and further characterised in that one output of said first counter chain (22) is connected to a bistable device (24) which changes from burst refresh to lower power refresh at the end of the count from said counter chain.

9. A system as claimed in Claim 8, and further characterised in that an output of said first counter chain (22) is connected to a divider chain (62) in turn connected to a passive delay line driver (65) to generate a pulse chain for driving the power down refresh circuit.

Fig.1.

INHIBIT NEXT ACCESS

+5V

PFAILDIS

Fig.2.

PFAILDIS

0246079

# Fig.3.

0246079